(19) **Europäisches Patentamt**
**European Patent Office**
**Office européen des brevets**

(11) **EP 2 420 115 B1**

(12) **EUROPEAN PATENT SPECIFICATION**

(45) Date of publication and mention
of the grant of the patent:
**08.04.2015 Bulletin 2015/15**

(51) Int Cl.:
***H05K 3/40*** *(2006.01)* ***B23B 41/00*** *(2006.01)*

(21) Application number: **09843436.8**

(86) International application number:
**PCT/US2009/040337**

(22) Date of filing: **13.04.2009**

(87) International publication number:
**WO 2010/120277 (21.10.2010 Gazette 2010/42)**

(54) **BACK DRILL VERIFICATION FEATURE**

RÜCKBOHRUNGSVERIFIKATIONSMERKMAL

ÉLÉMENT DE VÉRIFICATION DE CONTRE-PERÇAGE

(84) Designated Contracting States:
**AT BE BG CH CY CZ DE DK EE ES FI FR GB GR
HR HU IE IS IT LI LT LU LV MC MK MT NL NO PL
PT RO SE SI SK TR**

(74) Representative: **Rees, Simon John Lewis
Haseltine Lake LLP
Redcliff Quay
120 Redcliff Street
Bristol BS1 6HU (GB)**

(43) Date of publication of application:
**22.02.2012 Bulletin 2012/08**

(73) Proprietor: **Hewlett-Packard Development
Company, L.P.
Houston, TX 77070 (US)**

(72) Inventor: **MILLER, Joseph, P.
Houston
TX 77070 (US)**

(56) References cited:
**WO-A1-2009/023238      JP-A- 5 347 480
US-A1- 2002 196 613      US-A1- 2004 118 605
US-A1- 2005 128 672      US-A1- 2008 217 052
US-B1- 7 337 537         US-B2- 7 501 586**

Printed by Jouve, 75001 PARIS (FR)

**Description**

BACKGROUND

Circuit boards are often formed having multiple layers, with signal traces provided on inner and outer layers of the circuit board. To connect a signal trace on an inner layer of the board to a component, connector, or signal trace on an outer layer of the board, or to connect two signal traces on different inner layers, a via hole is drilled through the board that intersects one or more signal traces. Thereafter, the interior of the via hole is plated with a conductive material, thereby creating a conductive path from the signal trace on the inner layer to a component, connector, or signal trace on the outer layer, or to a signal trace on different layer.

Often an unneeded portion, or stub, of conductive material will remain. For example, if a signal trace is approximately midway between an upper and lower layer of the board, and a component or connector is coupled to the upper layer, an unneeded stub remains between the signal trace and the lower layer of the board. When high frequency signals are carried between the signal trace and the component, connector, or other signal trace, the unneeded stub can create an undesirable reflection, thereby reducing the maximum frequency that can be carried by the signal trace through the via hole to the component, connector, or other signal trace.

To increase the performance of circuit boards, boards are back drilled to remove unneeded stubs. A back drilling operation removes the conductive material from the via hole by drilling into the via hole with a drill bit slightly larger than the via hole. The drilling operation is performed from the layer of the board having the unneeded stub. For example, in the example mentioned above having a component or connector on the upper layer of the board, the back drill operation is performed from the lower layer of the board. The drill bit drills as close as practical to the signal trace, without breaking the connection between the signal trace and the conductive material in the via hole that completes the connection to the component, connector, or other signal trace.

US 2004/0118605 discloses separating multiple conductor by severing conductive path in a via using a drilling operation.

US 2008/02170052 A1 which is considered to represent the closest prior art discloses to back drill a PCB having an inner conducting layer connected to a plated via. The plated via has land parts on the two surfaces of the PCB with a diameter larger than the plated via. One land part and the conducting material in the via is removed by back drilling from one surface of the PCB up to the inner layer in order to avoid high frequency reflections from this part.

The invention is defined in the appended claims.

BRIEF DESCRIPTION OF THE DRAWINGS

The Figures depict embodiments, implementations, and configurations of the invention, and not the invention itself.

Figure 1 is a perspective view of a typical electronic device, such as a computer system, in which embodiments of the present invention may be deployed.

Figures 2-4 are side cutaway views of a circuit board, and illustrate a typical back drill operation.

Figures 5-13 and 15 are side cutaway views of a circuit board shown in Figure 1, and illustrate back drill verification features in accordance with embodiments of the present invention.

Figures 14 is a sectional view taken along section line 14-14 of Figure 13.

Figure 16 is a sectional view taken along section line 16-16 of Figure 15.

Figure 17 shows a test signal.

DETAILED DESCRIPTION

In the foregoing description, numerous details are set forth to provide an understanding of the present invention.

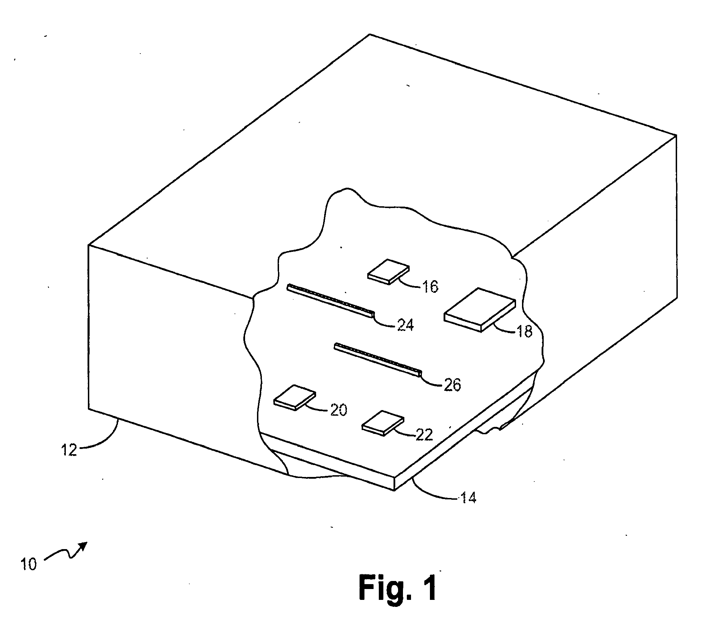

Embodiments of the present invention relate to a back drill verification feature that increases the detectability of a missed or improper back drill operation. Figure 1 is a perspective view of a typical electronic device 10, such as a computer system, in which embodiments of the present invention may be deployed. Device 10 has an enclosure 12 and a circuit board 14. Attached to circuit board 14 are components and connectors, such as components 16, 18, 20, and 22, and connectors 24 and 26. Note that Figure 1 is merely representative, and the present invention may be deployed in any product having a multi-layer circuit board, such as an add-on card configured to be installed in a computer system.

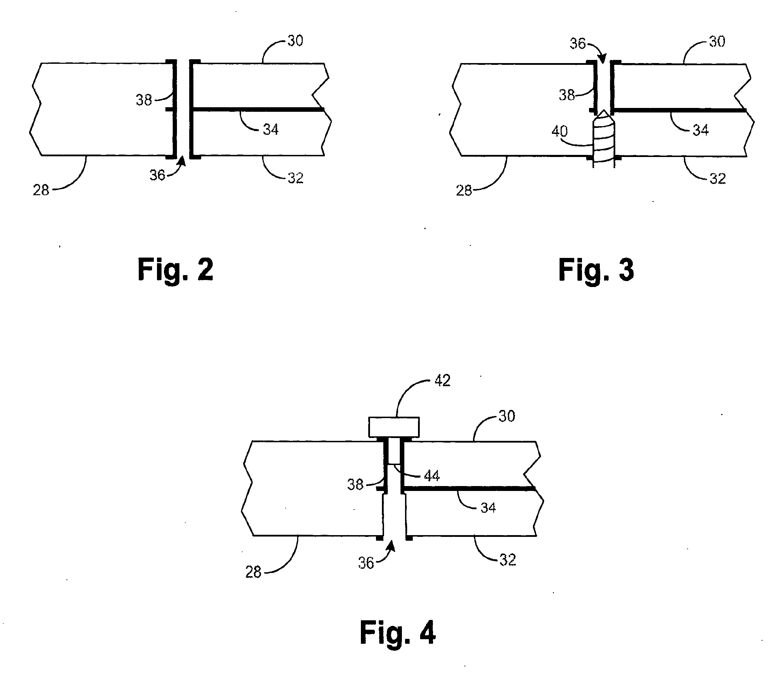

Figures 2-4 arc side cutaway views that illustrate a typical back drill operation. Figures 2-4 illustrate a via that connects a signal trace on an inner layer of the board to a connector or component on an outer layer of the board. However, those skilled in the art will recognize that back drill operations may also be performed on vias that connect signal traces on two or more different board layers.

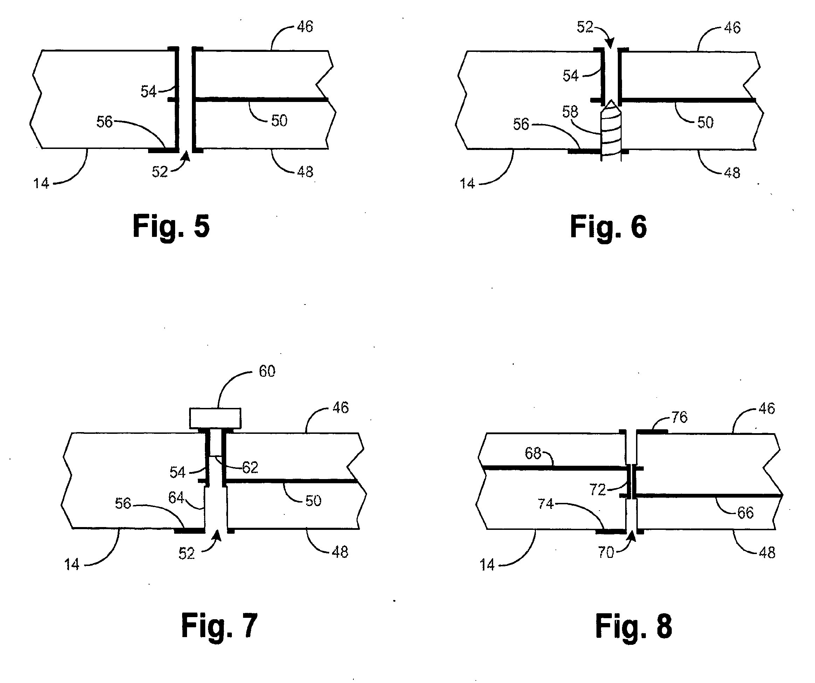

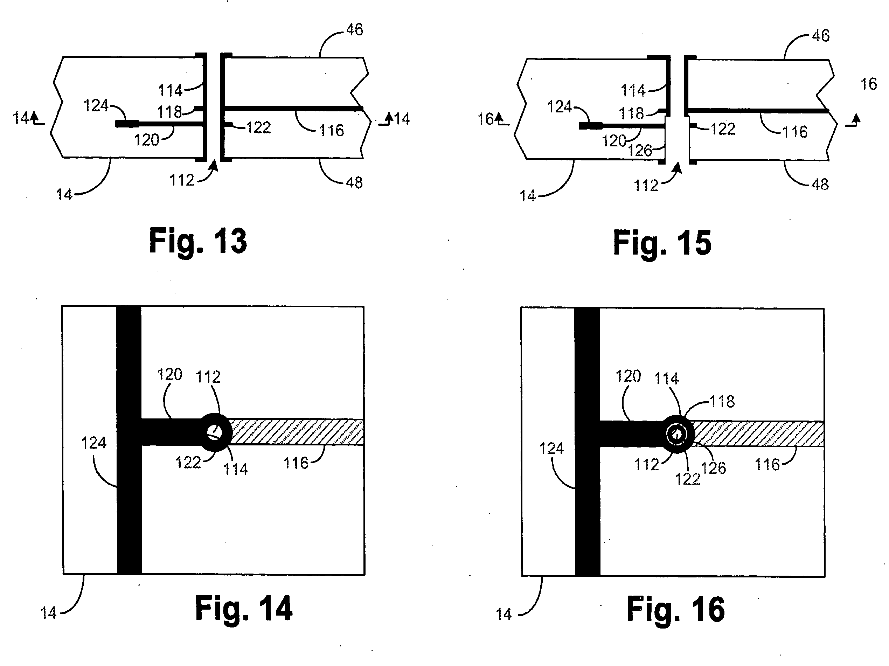

In Figure 2, board 28 has upper layer 30, lower layer 32, and an inner layer having a signal trace 34. Upper layer 30 and lower layer 32 are both outer layers. A via hole 36 was drilled through board 28, and the interior of via hole 36 was plated with conductive material 38. Note that a layer having a signal trace in electrical contact with conductive material 38 includes an annular ring that surrounds the via hole. In Figure 2-4 (as well as Figures 5-13 and 15), the annular ring is represented by the small stub on the side of the via hole opposite the side having the signal trace. The annular ring is shown in greater detail in the embodiment of the present invention shown in Figures 14 and 16.

As will be seen in Figure 4, a connector will be mounted on upper layer 30 of board 28. In Figure 2, note the stub of conductive material 38 that remains between signal trace 34 and lower layer 32 of board 28.

In Figure 3, a back drill operation is performed by drill bit 40 drilling into via hole 36 from lower layer 32 and removing the unneeded stub of conductive material 38. Drill bit 40 has a diameter slightly larger than the diameter of via hole 36.

Figure 4 shows the result of the back drill operation. Also shown in Figure 4 is connector 42, which has a pin 44 in electrical contact with conductive material 38, thereby completing the connection between signal trace 34 and pin 44 of connector 42. Note that connector 42 is merely representative, and conductive material 38 may be coupled to surface mounted components or connectors by other traces and pads, as will be shown in embodiments of the invention described below. The unneeded stub of conductive material 38 has been removed from via hole 36, thereby reducing signal reflections along the signal path from signal trace 34 to pin 44 of connector 42.

Although it may happen rarely, a back drill operation can be missed, or the back drill operation may not be performed properly. While back drilling provides a benefit, the effect can be small.

The velocity of propagation in a circuit board is given by:

$$V_p = \frac{C}{\sqrt{\varepsilon_r}}$$

where:

C= approximately $3 * 10^8$ meters per second, or about 30 cm/ns
$\varepsilon_r$ = effective dielectric constant
$V_p$ = velocity of propagation

Typical circuit board materials have an effective dielectric constant of 3.7-4.2, while more exotic and specialized circuit board materials may have an effective dielectric constant of 2.0-6.0.

Assume that a circuit board has an effective dielectric constant of 4, and a signal path on the board carries a 5 GHz signal. The wavelength of the signal is approximately 30 millimeters. If the board is 5 millimeters thick, and the signal trace is in the middle of the board, the back drilling operation will remove a stub having a length of approximately 2.5 millimeters.

A 2.5 millimeter stub will produce a small reflection, and therefore it is beneficial to remove the stub. However, a reflection will not cause a major degradation in signal quality until the conductor causing the reflection has a length of at least one-eighth of a wavelength or greater. In general, there is a continuum from very small fractions of wavelengths that cause minor degradations to a severe degradation at one-fourth of a wavelength. For a 5GHz signal carried by the signal path mentioned above, one-eighth of a wavelength is 3.75 millimeters. Therefore, the relatively small reflection caused by the unneeded stub creates a correspondingly small degradation in the signal.

Testing for a missed or improper back drill operation can be difficult, since the small degradation in the signal could also be caused by other factors, such as a poor connection between a pin and the conductive material in a via hole, or a poorly formed signal trace.

Embodiments of the present invention expose a missed or improperly performed back drill operation. A back drill verification feature is provided that intersects a via hole at a different layer than a signal trace. Before the back drill operation is performed, a conductive path is present between the back drill verification feature and the conductive material in the via hole. The back drill operation severs the connection between the conductive material and the via hole.

In one embodiment, the back drill verification feature has a length tuned to create a detectable reflection at a testing frequency. In another embodiment, the back drill verification feature is configured to be accessible to a circuit board tester, such as a "bed of nails" tester. If the portion of the back drill verification feature that intersects the via hole comprises a signal trace that is provided on an outer layer of the circuit board, the back drill verification feature may be accessed directly from the outer layer by making contact with the signal trace of the back drill verification feature. Alternatively, if the portion of the back drill verification feature that intersects the via hole comprises a signal trace that is provided on an inner layer of the circuit board, the back drill verification feature may include a via hole with conductive material provided therein to cause the back drill verification feature to be accessible at an outer layer of the circuit board. In yet another embodiment, the back drill verification feature is configured to create a short between a signal trace and another signal, such as a power or ground signal.

Circuit boards upon which back drill operations are performed have typical thicknesses of two millimeters to six millimeters. Furthermore, modern circuit boards may have 30 or more layers. Via holes drilled to connect a signal trace from an inner layer to a component or connector on an outer layer of the circuit board are typically 0.5-1.0 millimeters in diameter. However, via holes may also be used to connect two signal traces present on different layers, as will be discussed in greater detail below. Typically, a via hole for connecting signal traces on different layers is approximately 0.3 millimeters in diameter.

Note that in the Figures discussed herein, the relative scales of various features have been selected to illustrate more clearly embodiments of the present invention. However, when embodiments of the present invention are deployed in an actual circuit board, dimensions, such as the exemplary dimensions discussed above, will be used. Also note that multilayer boards are formed having signal traces on multiple layers, with electrical insulation provided between the layers, as is known in the art. To more clearly illustrate the present invention, only the signal traces are shown.

Figures 5-8 are side cutaway views that illustrate embodiments of the present invention having back drill verification features that initially intersect conductive material in via holes at outer layers of a circuit board. Embodiments of the present invention may deployed in circuit board 14 of electronic device 10 shown in Figure 1, as well as other devices employing circuit boards, as are known in the art.

In Figure 5, circuit board 14 has upper layer 46, lower layer 48, and an inner layer having signal trace 50. Upper layer 46 and lower layer 48 are outer layers. Via hole 52 was drilled through board 14, and via hole 52 was plated with conductive material 54. As will be discussed below with reference to Figure 7, a connector 60 will be mounted to upper layer 46 of board 14. A stub of conductive material 54 that remains between signal trace 50 and lower layer 48 of circuit board 14 is electrically coupled to back drill verification feature 56.

In Figure 6, a back drill operation is performed by drill bit 58 drilling into via hole 52 from lower layer 48 and removing the unneeded stub of conductive material 54. The back drill operation also severs the electrical connection between conductive material 54 and back drill verification feature 56.

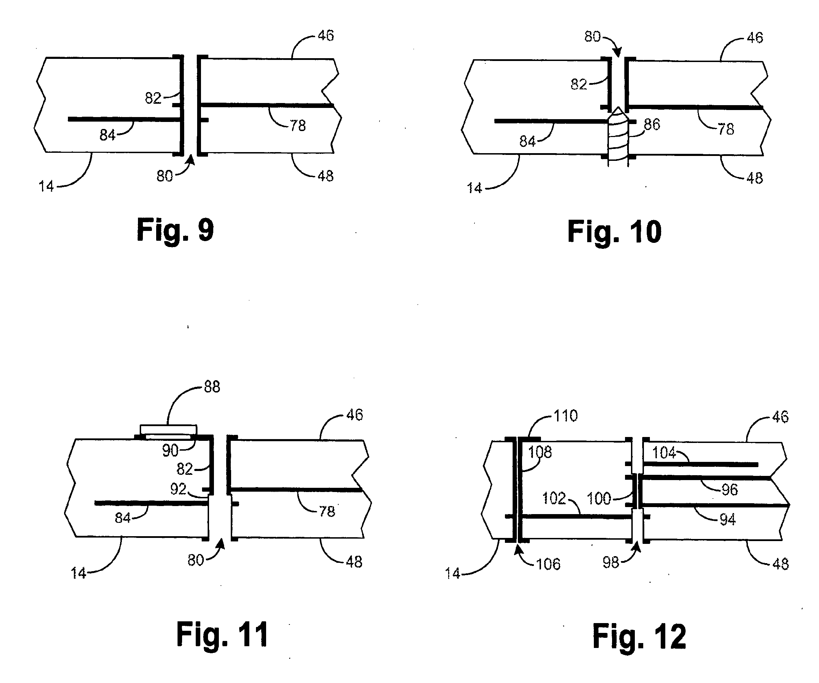

The results are shown in Figure 7. Note that Figure 7 includes connector 60, which has a pin 62 in electrical contact with conductive material 54, thereby completing the electrical connection between signal trace 50 and pin 62 of connector 60. Connector 60 may represent any of the connectors 24 or 26 shown in Figure 1. Also note that the conductive material in a via hole may couple a signal trace to a surface mounted component or connector, as shown in the embodiment of Figure 11, which will be discussed below.

Note the gap 64 created by the back drill operation between conductive material 54 and back drill verification feature 56. Gap 64 electrically isolates back drill verification feature 56 from conductive material 54.

Figures 5-7 illustrate embodiments suitable for a via hole that couples a signal trace on an inner layer to a component or connector on an outer layer of a circuit board. A similar technique may be used to couple a first signal trace on an inner layer to a second signal trace on an outer layer of a circuit board. As mentioned above, a via hole can also be used to connect two signal traces present on different inner layers of a circuit board. Such a configuration is shown in Figure 8, in accordance with an embodiment of the present invention.

In Figure 8, board 14 has signal trace 66 provided on a first inner layer and signal trace 68 provided on a second inner layer. Two back drill operations, similar to the back drill operation shown in Figure 6, have been performed, with a first back drill operation into via hole 70 from lower layer 48 of board 14 approaching signal trace 66, and a second back drill operation into via hole 70 from upper layer 46 of board 14 approaching signal trace 68. The unneeded stubs of conductive material 72 from signal trace 68 to upper layer 46 of board 14, and from signal trace 66 to lower layer 48 of board 14 have been removed. Conductive material 72 remaining after the first and second back drill operations electrically couples signal traces 66 and 68.

Back drill verification feature 74 on lower layer 48 of board 14 was electrically coupled to conductive material 72 before the first back drill operation, and the first back drill operation severed the connection between back drill verification feature 74 and conductive material 72. Similarly, back drill verification feature 76 on upper layer 46 of board 14 was electrically coupled to conductive material 72 before the second back drill operation, and the second back drill operation severed the connection between back drill verification feature 76 and conductive material 72.

Figures 9-12 are side cutaway views that illustrate embodiments of the present invention having back drill verification features that initially intersect conductive material in via holes at inner layers of a circuit board. Embodiments of the present invention may deployed in circuit board 14 of electronic device 10 shown in Figure 1, as well as other devices employing circuit boards, as are known in the art.

In Figure 9, circuit board 14 has upper layer 46, lower layer 48, and an inner layer having signal trace 78. Upper layer 46 and lower layer 48 are outer layers. A via hole 80 was drilled through board 14, and the via hole was plated with conductive material 82. As will be discussed below with reference to Figure 11, a surface mounted component 88 will be mounted to upper layer 46 of board 14. A stub of conductive material 82 that remains between signal trace 78 and lower layer 48 of circuit board 14 is electrically coupled to back drill verification feature 84

In Figure 10, a back drill operation is performed by drill bit 86 drilling into via hole 80 from lower layer 48 and removing the unneeded stub of conductive material 82. The back drill operation also severs the electrical connection between conductive material 82 and back drill verification feature 84.

In the embodiments shown in Figures 5-8, an advantage provided by having the back drill testability feature on an outer layer of the circuit board is that a spring pin of a circuit tester can easily probe the back drill testability feature. However, the back drill operation severs the connection between the back drill testability feature and the conductive material in the via hole as soon as the drill bit penetrates the outer layer of the board. Accordingly, the embodiments shown in Figures 5-8 do not verify that the back drill operation was performed to a proper depth.

In contrast, the embodiments shown in Figures 9-12 can verify that the back drill operation was performed to a proper depth. Ideally, back drill testability feature 84 is provided on a layer as close as possible to signal trace 78, while maintaining sufficient separation to ensure that a proper back drill operation will sever the connection between back drill testability feature 84 and conductive material 82, without severing the connection between signal trace 78 and conductive material 82. Of course, back drill testability feature 84 may be provided on a layer more distant from signal trace 78, with the ability to detect proper drill depth diminishing in proportion with the number of layers separating signal trace 78 and back drill testability feature 84.

The results of the back drill operation shown in Figure 10 are shown in Figure 11. Note that Figure 11 includes surface mounted component 88, which is coupled to conductive material 82 via pad 90, thereby completing the electrical connection between signal trace 78 and component 88. Component 88 may represent any of the components 16, 18, 20, or 22 shown in Figure 1. As mentioned above, the conductive material in a via hole may also couple a signal trace to a surface mounted connector. As shown in Figure 7, the conductive material in a via hole may couple a signal trace to a connector having a pin. Any of these methods may be used with the various embodiments of the present invention to couple components and connectors to signal traces on inner layers, along with other appropriate methods known in the art.

Note the gap 92 between conductive material 82 and back drill verification feature 84, which was created by the back drill operation. Gap 92 electrically isolates back drill verification feature 84 from conductive material 82.

Figures 9-11 illustrate embodiments suitable for a via hole that couples a signal trace on an inner layer to a component or connector on an outer layer of a circuit board. A similar technique may be used to couple a first signal trace on an inner layer to a second signal trace on an outer layer of a circuit board. As mentioned above, a via hole can also be used to connect two signal traces present on different inner layers of a circuit board. Such a configuration is shown in Figure 12, in accordance with embodiments of the present invention. Figure 12 also includes a back drill testability feature that has a via hole with conductive material provided therein to allow the back drill testability feature to be probed at an outer layer of the circuit board, in accordance with embodiments of the invention.

In Figure 12, board 14 has signal trace 94 provided on a first inner layer, and signal trace 96 provided on a second inner layer. Two back drill operations, similar to the back drill operation shown in Figure 10, have been performed, with a first back drill operation into via hole 98 from lower layer 48 of board 14 approaching signal trace 94, and a second back drill operation into via hole 98 from upper layer 46 of board 14 approaching signal trace 96. The unneeded stubs of conductive material 100 from signal trace 96 to upper layer 46 of board 14, and from signal trace 94 to lower layer 48 of board 14 have been removed. Conductive material 100 remaining after the first and second back drill operations electrically couples signal traces 94 and 96.

Back drill verification feature 102 was electrically coupled to conductive material 100 before the first back drill operation, and the first back drill operation severed the connection between back drill verification feature 102 and conductive material 100. Similarly, back drill verification feature 104 was electrically coupled to conductive material 100 before the second back drill operation, and the second back drill operation severed the connection between back drill verification feature 104 and conductive material 100.

When using a circuit board tester with the embodiment shown in Figures 5-8, a spring pin of a circuit board tester can make contact with back drill verification feature 56 of Figures 5-7, and back drill verification features 74 and 76 of Figure 8, all of which are provided on an outer layer of board 14. Such testers are sometimes known in the art as "bed of nails" testers. With back drill verification features 84 and 104 shown in Figures 9-12, a circuit board tester cannot make direct contact with back drill verification features 84 and 104 (provided there are proper back drill operations) since features 84 and 104 are provided on inner layers and are not routed to an outer layer of board 14.

However, back drill verification feature 102 in Figure 12 includes a via hole 106 having an interior plated with conductive material 108, in accordance with an embodiment of the present invention. Accordingly, back drill verification feature 102 may be probed at pad 110 by a spring pin of a circuit board tester.

If the circuit tester finds electrical continuity between the back drill verification feature and the signal trace to which the back drill verification feature would have been electrically coupled before a proper back drill operation, then the back drill operation was missed, or was not properly performed. When using an embodiment of the present invention designed for use with a circuit board tester, the portion of the back drill verification feature present on an outer layer need only be large enough to serve as a test pad (e.g., 0.1-2.0 millimeters).

As discussed above, in various embodiments, a missed or improper back drill operation may also be detected by a back drill verification feature having a length tuned to a test frequency. In these embodiments, the back drill verification feature creates a detectable reflection at the test frequency.

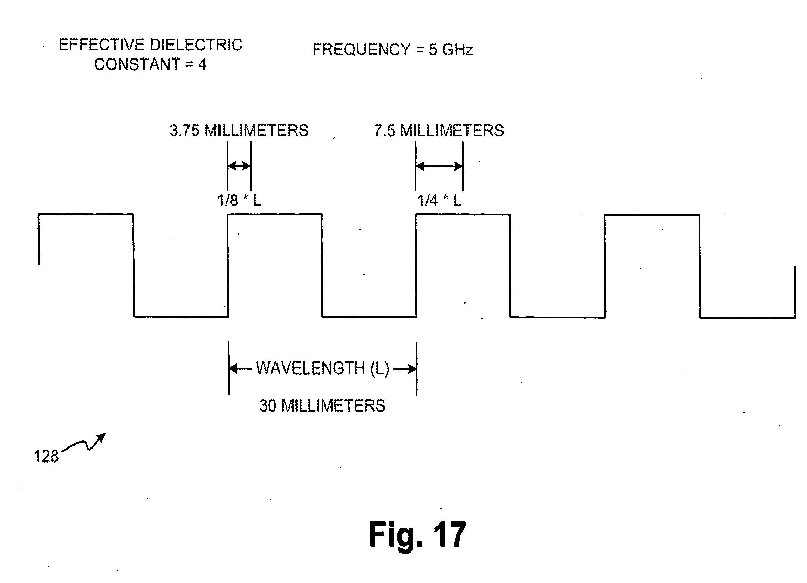

Consider the example of a signal trace carrying a test signal having a frequency of 5 GHz on a circuit board having an effective dielectric constant of 4, such as test signal 128 of Figure 17. Test signal 128 has a wavelength of approximately 30 millimeters. Note that test signal 128, which is shown as a square wave, is merely representative, and embodiments of the present invention may be used with many other types of test signals, such as signals carrying data strings having minimum bit lengths of one-half of a wavelength.

Typically, a reflection will begin to cause a substantial degradation in signal quality, and therefore begin to become easy to detect, when the length of the conductor causing the reflection is at least one-eighth the wavelength of the test signal, which in this example is 3.75 millimeters. A very detectable reflection will be created when the length of the conductor causing the reflection is at least one-fourth the wavelength of the test signal, which in this case is 7.5 millimeters. As mentioned above, there is a continuum from very small fractions of wavelengths that cause minor degradations to a severe degradation at one-fourth of a wavelength. By providing a back drill verification feature having a length tuned to a test frequency, the back drill verification feature creates a reflection that is easy to detect.

The reflection may be detected when a bare board is tested on a circuit board tester by applying the test signal at one end of a signal path before a via hole having a back drill operation to be verified, and measuring test signal at another end of the signal path after the via hole. Alternatively, the reflection may be detected in a completed circuit board. For example, many signal paths are verified by parity bits or cyclical redundancy code (CRC) bits. By providing a back drill verification feature tuned approximately to the test frequency carried by the signal trace, an improper or missing back drill operation is easily detected by running in-circuit test routines and diagnostics that transmit signals at frequencies having wavelengths roughly matched to the lengths of the back drill verification features, as described above. The in-circuit test routines and diagnostics may be invoked by a circuit tester exercising the completed board and invoking various testing features, such as boundary scans, and by applying signals to I/O pins. Also the in-circuit test routines and diagnostics may be invoked in the completed device. In these embodiments, all of the back drill verification features shown in Figures 5-12 may be provided with lengths appropriate for detecting reflections.

Finally, in another embodiment, the presence or absence of a short between the back drill verification feature and another signal, such as a power or ground signal may be used to detect a missing or improper back drill operation. This embodiment is shown in Figures 13-16.

Figure 13 shows this embodiment before a back drill operation. In Figure 13, board 14 has upper layer 46 and lower layer 48. Via hole 112 was drilled through board 14 and plated with conductive material 114. Signal trace 116 is provided on an inner layer of board 14 and is in electrical contact with conductive material 114 via annular ring 118. Back drill testability feature 120 is in electrical contact with conductive material 114 via annular ring 122, and is also in electrical contact with signal trace 124, which is transverse to back drill testability feature 120 and can be visualized as running perpendicular to the two-dimensional plane represented by Figure 13. Note that signal trace 124 is shown as being slightly larger than back drill testability feature 120 merely to highlight signal trace 124.

Figure 14 is a sectional view of circuit board 14 taken along section line 14-14 of Figure 13. Like Figure 13, Figure 14 also shows board 14 before a back drill operation. Accordingly, signal trace 124 is coupled to back drill testability feature 120, which in turn is coupled to conductive material 114 via annular ring 122. Signal trace 116 (shown in phantom) is also coupled to conductive material 114.

Figure 15 shows circuit board 14 after a back drill operation, such as the back drill operations shown in Figures 6 and 10. Accordingly, the back drill operation created gap 126 and severed the connection between signal trace 116 and back drill testability feature 120.

Figure 16 is a sectional view of circuit board 14 taken along section line 16-16 of Figure 15. Like Figure 15, Figure 16 also shows board 14 after the back drill operation. As seen in Figure 14, conductive material 114 remains in electrical contact with annular ring 118 and signal trace 116 (both shown in phantom). However, gap 126 separates conductive material 114 from annular ring 122 and back drill testability feature 120.

Note that in other embodiments, back drill verification feature 120 and signal trace 124 may be provided on outer layers. Furthermore, back drill verification feature 120 and signal trace 124 may be provided on different layers and connected by a via hole (which is not shown in Figures 13-16).

In this embodiment, an improper or missing back drill operation is detected by an electrical connection between conductive material 114 in via hole 112 (which will be coupled to other signal traces, connectors, or components), and signal trace 124. Note that after the back drill operation, back drill verification feature 120 remains electrically coupled to signal trace 124, thereby adding a small amount of additional capacitance to signal trace 124, and possibly creating a reflection for high frequency signals. Accordingly, it is desirable that signal trace 124 carry a low frequency or DC signal, such a ground signal or a supply voltage. Of course, any signal trace carrying any signal which is not significantly affected by the presence of the additional trace material that forms back drill verification feature 120 may be used. For example, signal trace 124 could carry a signal that is coupled to a status indicator LED on circuit board 14.

When a circuit board having this embodiment of the present invention is placed in a "bed of nails" test mixture, and a proper back drill operation has not been performed, the tester will detect an improper electrical connection from signal trace 124 through back drill verification feature 120 to the conductive material 114 in via hole 112. If connectivity is not present, the back drill operation has been performed properly. Of course, if a circuit board 14 with this embodiment is fully assembled, and back drill operations were not properly performed, the board may not function. Whether the circuit board functions will be dependent on which back drill operations were not performed properly, and the signal carried by signal trace 124. In any event, the improper or missing back drill operation will be detected by the fact that the board does not function, or does not function properly, or the improper or missing back drill operation will be detected by test routines and diagnostic routines performed by components on circuit board 14.

Embodiments of the present invention exaggerate effects associated with a failure to perform a back drill operation, or an improperly performed back drill operation. The present invention causes missing or improper back drill operations to be easily detected by a board tester, or in-circuit test routines and diagnostics. Embodiments of the present invention may be implemented with little additional cost, since all that is needed are the signal traces that form the back drill verification features, in accordance with embodiments of the present invention.

**Claims**

1. A circuit board (14) comprising:

   a first signal trace (50, 66, 78, 94, 116) present on a first inner layer of the circuit board (14); a via hole (52, 70, 80, 98, 112) drilled through the circuit board (14) and intersecting the first signal trace (50, 66, 78, 94, 116); conductive material (54, 72, 82, 100, 114) in the via hole (52, 70, 80, 98, 112) and in electrical contact with the first signal trace (50, 66, 78, 94, 116); and a first back drill verification feature (56, 74, 84, 102, 120) on a first layer of the circuit board (14), wherein the first inner layer and the first layer are different layers, a first electrical connection between the first back drill verification feature (56, 74, 84, 102, 120) and the conductive material (54, 72, 82, 100, 114), the first electrical connection being configured to be severable by the first back drill operation, wherein the first back drill verification feature (56, 74, 84) comprises a back drill verification signal trace having a length tuned to create a detectable reflection based on a wavelength of a test signal (128) carried by the first signal trace (50, 66, 78).

2. The circuit board (14) according to claim 1 and further comprising:

   a second signal trace (68, 96) present on a second inner layer of the circuit board (14), the via hole (70, 98) intersecting the second signal trace (68, 96), and the second signal trace (68, 96) in electrical contact with the conductive material (72, 100); and a second back drill verification feature (76, 104) on a second layer of the circuit board (14), wherein the second inner layer and the second layer are different layers, a second electrical connection existed between the second back drill verification feature (76, 104) and the conductive material (72, 100) before a second back drill operation, the second electrical connection being configured to be severable by the second back drill operation.

3. The circuit board (14) according to claim 1 wherein the length is equal to or greater than one-eighth the wavelength of the test signal (128).

4. The circuit board of (14) according to claim 1 wherein the first back drill verification feature (120) comprises a back drill verification signal trace in electrical contact with a second signal trace (124).

5. An electronic device (10) comprising:

   a circuit board (14); a signal trace (50, 66, 78, 94, 116) present on an inner layer of the circuit board (14); a via hole (52, 70, 80, 98, 112) drilled through the circuit board (14) and intersecting the signal trace (50, 66, 78, 94, 116); conductive material (54, 72, 82, 100, 114) in the via hole (52, 70, 80, 98, 112) and in electrical contact with the signal trace (50, 66, 78, 94, 116); a back drill verification feature (56, 74, 84, 102, 120) on a layer of the circuit board (14), wherein the inner layer and the layer are different layers, an electrical connection between the back drill verification feature (56, 74, 84, 102, 120) and the conductive material (54, 72, 82, 100, 114), the electrical connection being configured to be severable by the back drill operation; and a plurality of components (16, 18, 20, 22, 88) and connectors (24, 26, 60) mounted on a first outer layer (46) of the circuit board (14), with at least one of the plurality of components (16, 18, 20, 22, 88) and connectors (24, 26, 60) in electrical contact with the conductive material (54, 72, 82, 100, 114), wherein the back drill verification feature (56, 74, 84) comprises a back drill verification signal trace having a length tuned to create a detectable reflection based on a wavelength of a test signal (128) carried by the signal trace (50, 66, 78).

6. The electronic device (10) according to claim 5 wherein the back drill verification feature (56, 74, 102) includes a test pad (56, 74, 110) present on one of the first outer layer (46) or a second outer layer (48).

7. The electronic device (10) according to claim 6 wherein the back drill verification feature (102) includes a via hole (106) having conductive material (108) provided therein, with the conductive material (108) in electrical contact with the test pad (110).

8. The electronic device (10) according to claim 5 wherein the back drill verification feature (120) comprises a back drill verification signal trace in electrical contact with a second signal trace (124).

9. A method of verifying a back drill operation comprising:

drilling into a via hole (52, 70, 80, 98, 112) of a circuit board (14), thereby severing an electrical connection between conductive material (54, 72, 82, 100, 114) in the via hole (52, 70, 80, 98, 112) and a back drill verification feature (56, 74, 84, 102, 120), wherein a signal trace (50, 66, 78, 94, 116) is present on an inner layer of the circuit board (14) and is in electrical contact with the conductive material (54, 72, 82, 100, 114) and wherein the back drill verification feature (56, 74, 84, 102) comprises a back drill verification signal trace having a length tuned to create a detectable reflection based on a wavelength of a test signal (128) carried by the signal trace (50, 66, 78, 94).

10. The method according to claim 9 wherein the back drill verification feature (56, 74, 102) includes a test pad (56, 74, 110) present on an outer layer (46, 48) of the circuit board (14).

11. The method according to claim 9 wherein the back drill verification feature (120) includes a back drill verification signal trace in electrical contact with a signal trace (124) both before and after drilling into the via hole (112).

**Patentansprüche**

1. Leiterplatte (14), die Folgendes umfasst:

eine erste Signalspur (50, 66, 78, 94, 116), die auf einer ersten inneren Schicht der Leiterplatte (14) vorhanden ist;
ein Durchgangsloch (52, 70, 80, 98,112), das durch die Leiterplatte (14) gebohrt ist und die erste Signalspur (50, 66, 78, 94, 116) kreuzt;
leitfähiges Material (54, 72, 82, 100, 114) im Durchgangsloch (52, 70, 80, 98, 112), das mit der ersten Signalspur (50, 66, 78, 94, 116) im elektrischen Kontakt steht; und
eine erste Hinterbohrprüfeinrichtung (56, 74, 84, 102, 120) auf einer ersten Schicht der Leiterplatte (14), wobei die erste innere Schicht und die erste Schicht verschiedene Schichten darstellen; eine erste elektrische Verbindung zwischen der ersten Hinterbohrprüfeinrichtung (56, 74, 84, 102, 120) und dem leitfähigen Material (54, 72, 82, 100, 114), wobei die erste elektrische Verbindung dazu konfiguriert ist, durch den ersten Hinterbohrvorgang trennbar zu sein, wobei die erste Hinterbohrprüfeinrichtung (56, 74, 84) eine Hinterbohrprüfsignalspur umfasst, die eine Länge aufweist, die so ausgelegt ist, dass sie eine nachweisbare Reflexion erzeugt, die auf einer Wellenlänge eines Prüfsignals (128) basiert, die von der ersten Signalspur (50, 66, 78) getragen wird.

2. Leiterplatte (14) nach Anspruch 1, die ferner Folgendes umfasst:

eine zweite Signalspur (68, 96), die auf einer zweiten inneren Schicht der Leiterplatte (14) vorhanden ist, wobei das Durchgangsloch (70, 98) die zweite Signalspur (68, 96) kreuzt und die zweite Signalspur (68, 96) mit dem leitfähigen Material (72, 100) in elektrischem Kontakt steht; und
eine zweite Hinterbohrprüfeinrichtung (76, 104) auf einer zweiten Schicht der Leiterplatte (14), wobei die zweite innere Schicht und die zweite Schicht verschiedene Schichten darstellen, wobei eine zweite elektrische Verbindung vor einem zweiten Hinterbohrvorgang zwischen der zweiten Hinterbohrprüfeinrichtung (76, 104) und dem leitfähigen Material (72, 100) bestand, wobei die zweite elektrische Verbindung dazu konfiguriert ist, durch den zweiten Hinterbohrvorgang trennbar zu sein.

3. Leiterplatte (14) nach Anspruch 1, wobei die Länge gleich einem oder größer als ein Achtel der Wellenlänge des Prüfsignals (128) ist.

4. Leiterplatte (14) nach Anspruch 1, wobei die erste Hinterbohrprüfeinrichtung (120) eine Hinterbohrprüfsignalspur umfasst, die mit einer zweiten Signalspur (124) in elektrischem Kontakt steht.

5. Elektronisches Gerät (10), das Folgendes umfasst:

eine Leiterplatte (14);
eine Signalspur (50, 66, 78, 94, 116), die auf einer inneren Schicht der Leiterplatte (14) vorhanden ist;

ein Durchgangsloch (52, 70, 80, 98, 112), das durch die Leiterplatte (14) gebohrt ist und die Signalspur (50, 66, 78, 94, 116) kreuzt; leitfähiges Material (54, 72, 82, 100, 114) im Durchgangsloch (52, 70, 80, 98, 112), das mit der Signalspur (50, 66, 78, 94, 116) in elektrischem Kontakt steht; eine Hinterbohrprüfeinrichtung (56, 74, 84, 102, 120) auf einer Schicht der Leiterplatte (14), wobei die innere Schicht und die Schicht verschiedene Schichten darstellen; eine elektrische Verbindung zwischen der Hinterbohrprüfeinrichtung (56, 74, 84, 102, 120) und dem leitfähigen Material (54, 72, 82, 100, 114), wobei die elektrische Verbindung dazu konfiguriert ist, durch den Hinterbohrvorgang trennbar zu sein; und eine Vielzahl von Komponenten (16, 18, 20, 22, 88) und Steckverbindern (24, 26, 60), die auf einer ersten äußeren Schicht (46) der Leiterplatte (14) montiert sind, wobei mindestens eine/r aus der Vielzahl von Komponenten (16, 18, 20, 22, 88) und Steckverbindern (24, 26, 60) mit dem leitfähigen Material (54, 72, 82, 100, 114) in elektrischem Kontakt steht, wobei die Hinterbohrprüfeinrichtung (56, 74, 84) eine Hinterbohrprüfsignalspur umfasst, die eine Länge aufweist, die so ausgelegt ist, dass sie eine nachweisbare Reflexion erzeugt, die auf einer Wellenlänge eines Prüfsignals (128) basiert, das durch die Signalspur (50, 66, 78) getragen wird.

6. Elektronisches Gerät (10) nach Anspruch 5, wobei die Hinterbohrprüfeinrichtung (56, 74, 102) ein Testpad (56, 74, 110) umfasst, das entweder auf der ersten äußeren Schicht (46) oder einer zweiten äußeren Schicht (48) vorhanden ist.

7. Elektronisches Gerät (10) nach Anspruch 6, wobei die Hinterbohrprüfeinrichtung (102) ein Durchgangsloch (106) mit leitfähigem Material (108) darin umfasst, wobei das leitfähige Material (108) mit dem Testpad (110) in elektrischem Kontakt steht.

8. Elektronisches Gerät (10) nach Anspruch 5, wobei die Hinterbohrprüfeinrichtung (120) eine Hinterbohrprüfsignalspur umfasst, die mit einer zweiten Signalspur (124) in elektrischem Kontakt steht.

9. Verfahren zur Prüfung eines Hinterbohrvorgangs, umfassend:

Bohren in ein Durchgangsloch (52, 70, 80, 98, 112) einer Leiterplatte (14), dadurch Trennen einer elektrischen Verbindung zwischen leitfähigem Material (54, 72, 82, 100, 114) im Durchgangsloch (52, 70, 80, 98, 112) und einer Hinterbohrprüfeinrichtung (56, 74, 84, 102, 120), wobei eine Signalspur (50, 66, 78, 94, 116) auf einer inneren Schicht der Leiterplatte (14) vorhanden ist und mit dem leitfähigen Material (54, 72, 82, 100, 114) in elektrischem Kontakt steht, und wobei die Hinterbohrprüfeinrichtung (56, 74, 84, 102) eine Hinterbohrprüfsignalspur umfasst, die eine Länge aufweist, die so ausgelegt ist, dass sie eine nachweisbare Reflexion erzeugt, die auf einer Wellenlänge eines Prüfsignals (128) basiert, das durch die Signalspur (50, 66, 78, 94) getragen wird.

10. Verfahren nach Anspruch 9, wobei die Hinterbohrprüfeinrichtung (56, 74, 102) ein Testpad (56, 74, 110) umfasst, das auf einer äußeren Schicht (46, 48) der Leiterplatte (14) vorhanden ist.

11. Verfahren nach Anspruch 9, wobei die Hinterbohrprüfeinrichtung (120) eine Hinterbohrprüfsignalspur umfasst, die sowohl vor als auch nach dem Bohren in das Durchgangsloch (112) mit einer Signalspur (124) in elektrischem Kontakt steht.

**Revendications**

1. Carte à circuits (14) comprenant :

une première trace de signal (50, 66, 78, 94, 116) présente sur une première couche interne de la carte à circuits (14) ; un trou traversant (52, 70, 80, 98, 112) percé à travers la carte à circuits (14) et intersectant la première trace de signal (50, 66, 78, 94, 116) ; un matériau conducteur (54, 72, 82, 100, 114) dans le trou traversant (52, 70, 80, 98, 112) et en contact électrique avec la première trace de signal (50, 66, 78, 94, 116) ; et un premier élément de vérification de contreperçage (56, 74, 84, 102, 120) sur une première couche de la carte à circuits (14), la première couche interne et la première couche étant des couches différentes, une première connexion électrique étant entre le premier élément de vérification de contre-perçage (56, 74, 84, 102, 120) et le matériau conducteur (54, 72, 82, 100, 114), la première connexion électrique étant configurée pour pouvoir être rompue par la première opération de contre-perçage, le premier élément de vérification de contre-perçage (56, 74, 84) comprenant une trace de signal de vérification de contre-perçage ayant une longueur ajustée pour créer une réflexion détectable sur la base d'une longueur d'onde d'un signal de test (128) transporté par la première trace de signal (50, 66, 78).

2. Carte à circuits (14) selon la revendication 1, et comprenant en outre :

une seconde trace de signal (68, 96) présente sur une seconde couche interne de la carte à circuits (14), le trou traversant (70, 98) intersectant la seconde trace de signal (68, 96), et la seconde trace de signal (68, 96) étant en contact électrique avec le matériau conducteur (72, 100) ; et

un second élément de vérification de contre-perçage (76, 104) sur une seconde couche de la carte à circuits (14), la seconde couche interne et la seconde couche étant des couches différentes, une seconde connexion électrique existant entre le second élément de vérification de contre-perçage (76, 104) et le matériau conducteur (72, 100) avant une seconde opération de contre-perçage, la seconde connexion électrique étant configurée pour pouvoir être rompue par la seconde opération de contre-perçage.

3. Carte à circuits (14) selon la revendication 1, dans laquelle la longueur est égale ou supérieure à unhuitième de la longueur d'onde du signal de test (128).

4. Carte à circuits (14) selon la revendication 1, dans laquelle le premier élément de vérification de contre-perçage (120) comprend une trace de signal de vérification de contre-perçage en contact électrique avec une seconde trace de signal (124).

5. Dispositif électronique (10) comprenant :

une carte à circuits (14) ;
une trace de signal (50, 66, 78, 94, 116) présente sur une couche interne de la carte à circuits (14) ;
un trou traversant (52, 70, 80, 98, 112) percé à travers la carte à circuits (14) et intersectant la trace de signal (50, 66, 78, 94, 116) ;
un matériau conducteur (54, 72, 82, 100, 114) dans le trou traversant (52, 70, 80, 98, 112) et en contact électrique avec la trace de signal (50, 66, 78, 94, 116) ;
un élément de vérification de contre-perçage (56, 74, 84, 102, 120) sur une couche de la carte à circuits (14), la couche interne et la couche étant des couches différentes, une connexion électrique étant entre l'élément de vérification de contre-perçage (56, 74, 84, 102, 120) et le matériau conducteur (54, 72, 82, 100, 114), la connexion électrique étant configurée pour pouvoir être rompue par l'opération de contre-perçage ; et une pluralité de composants (16, 18, 20, 22, 88) et de connecteurs (24, 26, 60) montés sur une première couche externe (46) de la carte à circuits (14), au moins l'un de la pluralité de composants (16, 18, 20, 22, 88) et de connecteurs (24, 26, 60) étant en contact électrique avec le matériau conducteur (54, 72, 82, 100, 114), l'élément de vérification de contre-perçage (56, 74, 84) comprenant une trace de signal de vérification de contre-perçage ayant une longueur ajustée pour créer une réflexion détectable sur la base d'une longueur d'onde d'un signal de test (128) transporté par la trace de signal (50, 66, 78).

6. Dispositif électronique (10) selon la revendication 5, dans lequel l'élément de vérification de contre-perçage (56, 74, 102) comprend un plot de test (56, 74, 110) présent sur l'une de la première couche externe (46) ou d'une seconde couche externe (48).

7. Dispositif électronique (10) selon la revendication 6, dans lequel l'élément de vérification de contre-perçage (102) comprend un trou traversant (106) ayant un matériau conducteur (108) formé dans celui-ci, le matériau conducteur (108) étant en contact électrique avec le plot de test (110).

8. Dispositif électronique (10) selon la revendication 5, dans lequel l'élément de vérification de contre-perçage (120) comprend une trace de signal de vérification de contre-perçage en contact électrique avec une seconde trace de signal (124).

9. Procédé de vérification d'une opération de contre-perçage comprenant :

le perçage dans un trou traversant (52, 70, 80, 98, 112) d'une carte à circuits (14), rompant ainsi une connexion électrique entre un matériau conducteur (54, 72, 82, 100, 114) dans le trou traversant (52, 70, 80, 98, 112) et un élément de vérification de contre-perçage (56, 74, 84, 102, 120), une trace de signal (50, 66, 78, 94, 116) étant présente sur une couche interne de la carte à circuits (14) et étant en contact électrique avec le matériau conducteur (54, 72, 82, 100, 114) et l'élément de vérification de contre-perçage (56, 74, 84, 102) comprenant une trace de signal de vérification de contre-perçage ayant une longueur ajustée pour créer une réflexion détectable sur la base d'une longueur d'onde d'un signal de test (128) transporté par la trace de signal (50, 66, 78, 94).

10. Procédé selon la revendication 9, dans lequel l'élément de vérification de contre-perçage (56, 74, 102) comprend un plot de test (56, 74, 110) présent sur une couche externe (46, 48) de la carte à circuits (14).

11. Procédé selon la revendication 9, dans lequel l'élément de vérification de contre-perçage (120) comprend une trace de signal de vérification de contre-

**EP 2 420 115 B1**

perçage en contact électrique avec une trace de signal (124) à la fois avant et après perçage dans le trou traversant (112).

Fig. 1

Fig. 3

Fig. 2

Fig. 4

**Fig. 5**

**Fig. 6**

**Fig. 7**

**Fig. 8**

14

Fig. 9

Fig. 10

Fig. 11

Fig. 12

**Fig. 13**

**Fig. 15**

**Fig. 14**

**Fig. 16**

EP 2 420 115 B1

EFFECTIVE DIELECTRIC
CONSTANT = 4

FREQUENCY = 5 GHz

3.75 MILLIMETERS

7.5 MILLIMETERS

1/8 * L

1/4 * L

WAVELENGTH (L)

30 MILLIMETERS

128

**Fig. 17**

EP 2 420 115 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20040118605 A
- US 200802170052 A1